# EUROPÄISCHE PATENTSCHRIFT

(11) **EP 1 716 595 B1**
(45) Veröffentlichungstag und Bekanntmachung des Hinweises auf die Patenterteilung: **10.09.2008**
(21) Anmeldenummer: 05714950.2
(22) Anmeldetag: 09.02.2005
(51) Int. Cl.: H01L 25/065

(54) **HALBLEITERBAUTEIL MIT EINEM STAPEL AUS HALBLEITERCHIPS UND VERFAHREN ZUR HERSTELLUNG DESSELBEN**
SEMICONDUCTOR COMPONENT COMPRISING A STACK OF SEMICONDUCTOR CHIPS AND METHOD FOR PRODUCING THE SAME
COMPOSANT SEMI-CONDUCTEUR MUNI D'UN EMPILEMENT DE PUCES A SEMI-CONDUCTEURS ET PROCEDE PERMETTANT DE LE PRODUIRE

(30) Priorität: 18.02.2004 DE 102004008135
(43) Veröffentlichungstag der Anmeldung: 02.11.2006
(73) Patentinhaber: Infineon Technologies AG, 81669 München (DE)
(72) Erfinder: BAUER, Michael, 93152 Nittendorf (DE); ENGLING, Thomas, 98551 Königsbronn (DE); HAIMERL, Alfred, 93161 Sinzing (DE); KESSLER, Angela, 93053 Regensburg (DE); MAHLER, Joachim, 93051 Regensburg (DE); SCHOBER, Wolfgang, 92224 Amberg (DE)
(74) Vertreter: Schäfer, Horst
(86) Internationale Anmeldenummer: PCT/DE2005/000215
(87) Internationale Veröffentlichungsnummer: WO 2005/081315

(56) Entgegenhaltungen:
- WO-A-03/084297
- US-A- 5 637 536
- US-A1- 2003 006 493
- US-A1- 2003 071 341
- US-A1- 2003 132 527
- US-A1- 2003 175 411
- US-A1- 2003 218 191
- US-A1- 2004 155 326

## Beschreibung

Die Erfindung betrifft ein Halbleiterbauteil mit einem Stapel aus Halbleiterchips und Verfahren zur Herstellung desselben, wobei die Halbleiterchips Kontaktflächen aufweisen, die in dem Halbleiterchipstapel über Leitungsabschnitte elektrisch verbunden sind.

Die zunehmende Verdichtung insbesondere in der Hardware für Datenspeicherungen und Datenverarbeitung erfordert möglichst kompakte Halbleitermodule bei minimalem Raumbedarf. Eine Möglichkeit bietet das Stapeln von Halbleiterchips und/oder Halbleiterbauteilen zu einem Halbleitermodulstapel. Solche Stapel sind beispielsweise aus den amerikanischen Patentanmeldungsschriften US 2003/218191 A1, US 2003/132527 A1, US 2003/071341 A1 und US 2003/006493 A1 bekannt. Jedoch besteht ein Optimierungsproblem darin, dass die Komponenten eines gestapelten Halbleitermoduls raumsparend untereinander zu verdrahten sind. Die bisher bekannten Verdrahtungslösungen arbeiten mit Flipchip-Kontaktverbindungen und/oder mit Bondverbindungen, welche einen erheblichen Raumbedarf haben. Weitere Verbindungstechniken sehen zwischen den zu stapelnden Komponenten Umverdrahtungsplatten vor, um die Verdrahtung eines Chipstapels zu lösen, sodass ebenfalls der Raumbedarf hoch ist. Hinzu kommt, dass konventionelle Lösungen Randbedingung und Größenbedingung an die zu stapelnden Komponenten stellen, was eine frei wählbare Verdrahtung und das Stapeln von Halbleiterchips beliebiger Flächengrößen zu Halbleiterbauteilen behindert.

Aufgabe der Erfindung ist es, ein Halbleiterbauteil mit einem Stapel aus Halbleiterchips zu schaffen, wobei die Halbleiterchips eine unterschiedliche Größe aufweisen und dennoch eine zuverlässige, raumsparende elektrische Verbindung zwischen den gestapelten Halbleiterchips gewährleistet wird.

Diese Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird ein Halbleiterbauteil aus einem Stapel von Halbleiterchips geschaffen, wobei die Halbleiterchips des Halbleiterchipstapels stoffschlüssig aufeinander fixiert angeordnet sind. Dazu weisen die Halbleiterchips Kontaktflächen auf, die sich bis an die Kanten der Halbleiterchips erstrecken. Zusätzlich erstrecken sich Leitungsabschnitte von mindestens einer Oberkante zu einer Unterkante der Randseiten der Halbleiterchips, welche die Kontaktflächen der Halbleiterchips des Halbleiterchipstapels elektrisch verbinden.

Durch die stoffschlüssige Verbindung zwischen den Halbleiterchips und des Stapels wird der Raumbedarf minimiert auf die Dicke der Halbleiterchips, zumal derartige, stoffschlüssige, flächige Verbindungen zwischen den Halbleiterchips nur wenige Mikrometer in Anspruch nehmen. Die Dicke des Halbleiterchipstapels kann weiterhin durch Dünnen der gestapelten Halbleiterchips weiter vermindert werden. Durch das Heranführen der Kontaktflächen auf der aktiven Oberseite der Halbleiterchips bis an die Kanten des jeweiligen Halbleiterchips wird gewährleistet, dass die auf den Randseiten angeordneten Leitungsabschnitte einen sicheren elektrischen Kontakt zwischen den Kontaktflächen eines oberen Halbleiterchips und den Kontaktflächen eines darunter angeordneten Halbleiterchips herstellen können. Dazu müssen die beiden zu verbindenden Kontaktflächen nicht unmittelbar übereinander angeordnet sein, da die Leitungsabschnitte auf den Randseiten der Halbleiterchips auch Strukturen ermöglichen, bei denen die Kontaktflächen eines oberen und eines unteren Halbleiters gegeneinander versetzt angeordnet sind.

Die auf den Randseiten der Halbleiterchips sich erstreckende Leitungsabschnitte limitieren nicht die freie Wählbarkeit der Chipgrößen, die miteinander zu verbinden sind. So können in einer bevorzugten Ausführungsform der Erfindung die Halbleiterchips unterschiedliche Chipgrößen aufweisen. In dem Fall können die Leitungsabschnitte die zwei Kontaktflächen von zwei Chips unterschiedlicher Flächengrößen miteinander verbinden auf Randbereichen der aktiven Oberseite der Halbleiterchips oder auf Randbereichen der Rückseiten der Halbleiterchips derart geführt sein, dass nahezu beliebige Größenunterschiede zwischen den Halbleiterchips vorherrschen können und durch die Leitungsführung überwunden werden. Ein weiterer Vorteil dieser Erfindung ist es, dass auch alternierend, großflächige und kleinflächige Halbleiterchips übereinander gestapelt sein können, da die Leitungsabschnitte entlang der Randseiten, der Oberseiten und der Rückseiten der Halbleiterchips beliebig geführt werden können.

Durch die Verlegung der Kontaktflächen an die Kanten der Halbleiterchips ist eine derartige Verdrahtung auf den Randseiten der Halbleiterchips und damit auf den Randseiten des Halbleiterbauteils in Kombination mit Verdrahtungen auf nicht bedeckten aktiven Oberseiten und Rückseiten der Halbleiterchips möglich. Die Flexibilität dieser Leitungsführung, die sich auf die Randseiten eines Halbleiterchipstapels beschränkt, hat den Vorteil gegenüber herkömmlichen Lösungen, dass die Halbleiterchips vollflächig, ohne Rücksicht auf irgendwelche Flipchip-Kontakte oder Kontaktanschlussflächen oder Umverdrahtungsplatten, auf minimalem Raum aufeinander geklebt, gelötet oder diffusionsgelötet werden können. Damit werden Stapel aus Halbleiterchips möglich, bei denen das Übersprechen minimiert ist und das Rückkoppeln von Signalen über parasitäre Induktivitäten unterbunden bleibt.

Auch ist es möglich, dass die Halbleiterchips eine unterschiedliche Anzahl von Kontaktflächen an ihren Kanten aufweisen. Entsprechend wird dann ein Verdrahtungsplan vorgesehen, der dieser unterschiedlichen Anzahl von Kontaktflächen Rechnung trägt.

Im Gegensatz zu Bonddrähten oder Flipchip-Kontakten sind die elektrisch leitenden Leitungsabschnitte auf die Halbleiterchipkanten, den Halbleiterrandseiten, den Halbleiteroberseiten und/oder den Halbleiterrückseiten haftend angeordnet. Somit ist die Raumersparnis optimal, da keinerlei Bondschleifen oder andere Abstände durch beispielsweise Flipchip-Kontakte den Raumbedarf vergrößern. Somit stellt das erfindungsgemäße Halbleiterbauteil mit einem Stapel von Halbleiterchips eine bisher nicht erreichte höchste Verdichtung, insbesondere in der Hardware für Datenspeicherungen und Datenverarbeitung, dar.

Um eine derartige Leitungsführung zu erreichen, weisen die Leitungsabschnitte einen anhaftenden Kunststofflack auf, der mit metallischen Nanopartikeln gefüllt ist und elektrisch leitet, sobald die Nanopartikel zu Leitungsabschnitten zusammengeschweißt oder -geschmolzen sind. Dazu ist der mit Nanopartikeln gefüllte Kunststofflack in einem Lösungsmittel löslich, und kann an den Stellen, an denen nicht Leitungsabschnitte entstehen, von den Seitenrändern, den Oberseiten, den Randseiten und den Rückseiten der Halbleiterchips abgelöst werden. Zur Verdichtung der Nanopartikel zu Leitungsabschnitten können Laserschreibgeräte eingesetzt werden, die mit ihrem Laserstrahl einerseits die Nanopartikel verdichten und zusammenschmelzen und andererseits den Kunststofflack verdampfen.

Eine Strukturierung ist auch photolithographisch möglich, wenn der Kunststofflack entsprechende Eigenschaften besitzt, jedoch muss anschließend die Leiterbahn mit den kunststoffeingebetteten Nanopartikeln nochmal extra behandelt werden, um die Nanopartikel miteinander zu verschmelzen. Ferner ist es möglich, anstelle einzelner, einschichtiger Leiterbahnabschnitte auf den Randseiten des Stapels auch mehrlagige Umverdrahtungsschichten vorzusehen, bei denen sich Nanopartikel gefüllte, elektrisch leitende und strukturierte Kunststofflackschichten und dazwischen angeordnete Isolationsschichten auf den Randseiten der Halbleiterchips abwechseln. Somit ist es möglich, komplexe Schaltungsmuster auf den Randseiten des Halbleiterchipstapels unterzubringen, die mit herkömmlicher Bonddrahttechnologie oder mit herkömmlicher Flipchip-Technologie nicht realisierbar sind.

Ein Verfahren zur Herstellung eines Halbleiterbauteils mit einem Stapel aus Halbleiterchips, weist die nachfolgenden Verfahrensschritte auf.

Zunächst werden Halbleiterchips hergestellt mit Kontaktflächen, die sich bis an die Kanten des jeweiligen Halbleiterchips erstrecken. Anschließend wird eine stoffschlüssige Fixierung der Halbleiterchips übereinander zu einem Stapel durchgeführt. Danach kann dieser kompakte Stapel aus Halbleiterchips mit einer Schicht aus mit einem mit Nanopartikeln gefüllten Kunststofflack umhüllt werden. Abschließend wird dann diese äußere leitende Hüllenschicht zu Leiterbahnabschnitten zwischen den Kontaktflächen aufeinander gestapelten Halbleiterchips strukturiert.

Dieses Verfahren hat den Vorteil, dass damit die bisher höchstmögliche Verdichtung, insbesondere in der Hardware für Datenspeicher und Datenverarbeitung, möglich wird. Dabei ist von besonderem Vorteil, dass die Kontaktflächen nicht mehr im Randbereich einer Oberseite eines Halbleiterchips angeordnet werden, sondern bis an die Kanten des Halbleiterchips heranreichen. Somit können diese Kanten der Kontaktflächen nach dem stoffschlüssigen Fixieren der Halbleiterchips übereinander durch die umhüllende leitende Schicht zunächst über die Nanopartikel kurzgeschlossen werden. Diese Leitung kann dann strukturiert werden, und dieser Strukturierung stehen alle Freiheitsgrade einer dreidimensionalen Verdrahtung zur Verfügung, sodass vorteilhafterweise der Stapel aus Halbleiterchips verschiedene Halbleiterchipgrößen aufweisen kann und keine Größenstufung vorgesehen werden muss, wie dass bei herkömmlichen Technologien zum Stapeln von Halbleiterchips Voraussetzung ist, um das oberste Halbleiterchip mit dem untersten Halbleiterchip eines Stapels zu verdrahten.

Das Aufbringen der Schicht, aus mit Nanopartikeln gefüllten Kunststofflack auf den Halbleiterstapel, kann mittels einer Sprühtechnik erfolgen. Derartige Sprühtechniken sorgen für einen relativ gleichmäßigen Auftrag des mit Nanopartikeln gefüllten Kunststofflackes, der dann zu Leitungsabschnitten strukturiert wird.

Bei einer weiteren bevorzugten Durchführung des Verfahrens wird der Halbleiterstapel zum Umhüllen mit einer Schicht aus Kunststofflack in ein Bad aus mit Nanopartikeln gefülltem Kunststofflack eingetaucht. Der Vorteil einer derartigen Tauchtechnik ist es, dass eine Massenproduktion und ein Massenbeschichten des Halbleiterstapels möglich wird, jedoch sind die dabei erreichten Dicken wesentlich höher, als bei der Sprühtechnik.

Für das Strukturieren des mit Nanopartikeln gefüllten Kunststofflackes wird ein Laserablationsverfahren eingesetzt, das einerseits den Kunststofflack verdampft und andererseits die Nanopartikel zu Leiterbahnen verschweißt. Dort wo kein Laserabtrag des Kunststofflackes, und damit auch kein Verschweißen der Nanopartikel, stattfindet, kann der mit Nanopartikeln gefüllte Kunststofflack durch entsprechende Lösungsmittel abgelöst oder abgewaschen werden.

Prinzipiell ist es auch möglich, dass das Strukturieren der mit Nanopartikeln gefüllten Schicht aus Kunststofflack zu Leiterbahnabschnitten mittels der Photolithographieverfahren durchzuführen. Hier kann aufgrund der stark strukturierten Seitenränder der aufeinander gestapelten Halbleiterchips beispielsweise mit einer Projektionsphotolithographie erfolgreich gearbeitet werden.

Schließlich ist es möglich, die Leiterbahnabschnitte nicht in Form einer Umhüllung und einer anschließenden Strukturierung einer Schicht zu erreichen, sondern sie von vornherein selektiv mittels Präzisionsspritztechniken aufzubringen. Bei diesen Präzisionsspritztechniken wird ein wenige Mikrometer feiner Stahl aus Kunststofflack, der mit Nanopartikeln gefüllt ist, auf die Randseiten des Halbleiterchipstapels gespritzt. Damit werden praktisch die Leiterbahnabschnitte auf den Randseiten des Halbleiterstapels gezeichnet.

Ist die Verbindungsdichte zwischen den gestapelten Halbleiterchips zu erhöhen, so ist es auch möglich mehrlagige Leiterbahnabschnitte im Wechsel mit Isolationsschichten auf den Halbleiterstapel entweder selektiv oder mithilfe des Laserabtragsverfahrens oder mithilfe der Photolithographie zur Bearbeitung aufzubringen. Mit dieser Verfahrensvariante kann die Anzahl der Leitungsabschnitte, welche die Kontaktflächen der einzelnen Halbleiterchips auf einem Halbleiterchipstapel verbinden, in vorteilhafterweise beliebig erhöht werden.

Zusammenfassend ist festzustellen, dass durch die Erfindung eine Herstellung von gestapelten Halbleiterchips mit kleinstmöglicher räumlicher Verdrahtung und mit Geometrie unabhängigen Chipgrößen realisierbar ist. Damit werden teure Umverdrahtungsplatten zwischen den gestapelten Halbleiterchips vermieden. Auch Zwischenkontaktlagen, wie beispielsweise Flipchip-Kontakte oder Bonddrahtverbindungen, werden mit der vorliegenden Erfindung überflüssig. Dazu werden die Kontaktflächen der Halbleiterchips bis nach außen an die Halbleiterchipkanten geführt. Dies kann bereits im Frontend oder mit einer dünnen auf die aktive Oberseite der Halbleiterchips aufzubringenden Umverdrahtungslage erfolgen.

Anschließend werden die zu stapelnden Halbleiterchips miteinander stoffschlüssig verbunden. Dies kann durch einen Klebeprozess oder einen Lötprozess oder einen Diffusionslötprozess erfolgen. Dieser Chipverbund als Halbleiterchipstapel wird danach in eine mit elektrisch leitfähigen metallischen oder metallisch beschichteten Nanopartikeln gefüllte Lösung getaucht oder alternativ wird diese Lösung auf den Stapel aus Halbleiterchips aufgesprüht. Anschließend können die Partikel mittels Laserbeschuss strukturiert und zu Leiterbahnen zusammengeschmolzen werden. Die überschüssige Partikellösung, die nicht zu Leiterbahnen zusammengebracht wurde, wird danach durch entweder Abwaschen oder Eintauchen in ein geeignetes Lösungsmittel entfernt.

Auch sind auf diese Weise mehrlagige Umverdrahtungsstrukturen herstellbar und können durch zusätzlich Prozessschritte durch Einbringen von entsprechenden Isolationsschichten aus einem Dielektrikum aufgebracht werden. Notwendige Durchkontaktierungen zu den aktiven Oberseiten der Halbleiterchips können ebenfalls mittels Laserabtrag freigelegt werden und anschließend kann erneut über eine Nanopartikellösung eine leitende Verbindung aufgebracht und strukturiert werden. Zum Abschluss kann der Halbleiterchipstapel auch auf einen Basischip oder auf einen entsprechenden Träger aufgebracht werden oder an seinen Außenseiten mit Außenkontakten versehen werden.

Wenn zum Schutz des Halbleiterchipstapels und der Kontaktflächen, sowie der Umverdrahtung aus Nanopartikeln eine schützende Kunststoffkappe vorzusehen ist, so können billigere und höher viskose Pressmassen als bisher bei dem Moldprozess vorgesehen werden, zumal der Halbleiterchipstapel einen stabilen und kompakten Halbleiterkörper bildet. Bei dieser Art der Stapelung entfallen sämtliche Drahtverbindungen. Insbesondere lassen sich sehr dünne Gehäuse zuverlässig realisieren, da der Raumbedarf für Drähte, für Höckerkontakte oder für Flipchip-Kontakte entfällt.

Die Erfindung wird nun anhand der beigefügten Figuren näher erläutert.
- Figur 1: zeigt einen schematischen Querschnitt durch ein Bauteil mit einem Halbleiterchipstapel einer ersten Ausführungsform der Erfindung;
- Figur 2: zeigt eine schematische Draufsicht auf ein Halbleiterbauteil mit einem Halbleiterchipstapel einer zweiten Ausführungsform der Erfindung;
- Figur 3: zeigt einen schematischen Querschnitt durch vier aufeinander gestapelte Halbleiterchips zur Herstellung eines Halbleiterbauteils mit einem Halbleiterchipstapel einer dritten Ausführungsform der Erfindung;
- Figur 4: zeigt den schematischen Querschnitt des Halbleiterchipstapels der Figur 3 nach Umhüllen des Halbleiterchipstapels mit einer Nanopartikel aufweisenden Schicht;
- Figur 5: zeigt eine Seitenansicht des Halbleiterbauteils der dritten Ausführungsform der Erfindung nach Strukturieren der Nanopartikel aufweisenden Schicht, die in Figur 4 gezeigt wird;

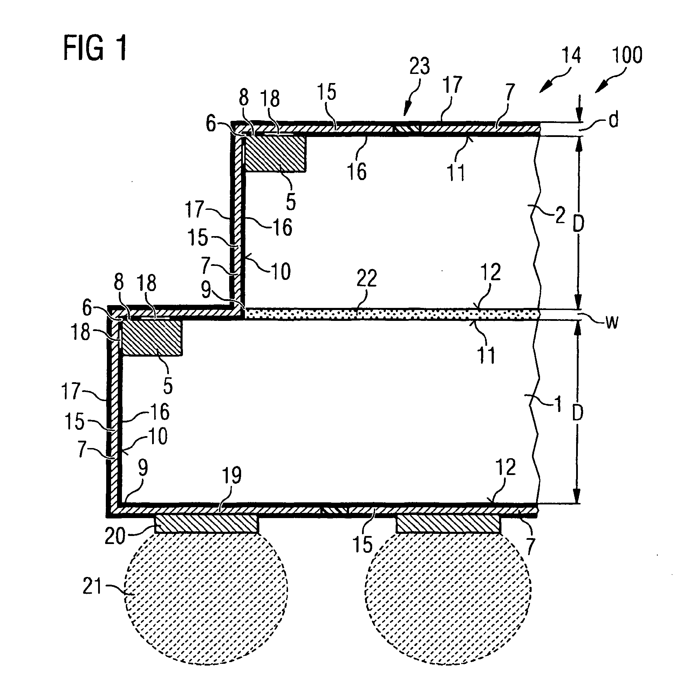

Figur 1 zeigt einen schematischen Querschnitt durch ein Halbleiterbauteil 14 mit einem Halbleiterchipstapel (100) einer ersten Ausführungsform der Erfindung. Der Halbleiterchipstapel 100 weist einen unteren Halbleiterchip 1 und einen darauf gestapelten oberen Halbleiterchip 2 auf. Die Halbleiterchips 1, 2 weisen Oberseiten 11, Rückseiten 12 und Randseiten 10 auf. In dieser ersten Ausführungsform der Erfindung ist die Oberseite 11 des unteren Halbleiterchips 1, welche die aktiven Halbleiterelemente einer integrierten Schaltung trägt, mit der Rückseite 12 des oberen Halbleiterchips 2 stoffschlüssig verbunden. Die Oberseiten 11 der Halbleiterchips 1 und 2 weisen Kontaktflächen 5 auf, die sich bis an die Kanten 6 der Oberseiten 11 der Halbleiterchips 1 und 2 erstrecken.

Diese Kanten, die hier die Kontaktflächen 5 aufweisen, werden im folgenden Oberkanten 8 genannt und die Kanten, die sich zwischen den Randseiten 10 und der Rückseite 12 der Halbleiterchips 1 und 2 ausbilden, werden im Folgenden als Unterkanten 9 gekennzeichnet. Der Stapel 100 aus Halbleiterchips 1 und 2 ist von einer Isolationsschicht 16 auf seinen Oberflächen bedeckt und weist im Bereich der Kontaktflächen 5 Fenster 18, sowohl auf den Randseiten 10, als auch auf den Oberseiten 11 auf, sodass auf diese Kontaktflächen an den Kanten 6 zugegriffen werden kann.

Auf dieser Isolationsschicht 16 mit Fenstern 18 zu den Kontaktflächen 5 ist eine strukturierte Schicht 15 aus mit Nanopartikeln gefülltem Kunststofflack aufgebracht, die in dieser Ausführungsform der Erfindung zur Unterseite des Halbleiterstapels 100 Kontaktfenster 19 aufweist, über die auf die elektrisch leitende Schicht 15 aus mit Nanopartikeln gefülltem Kunststofflack zugegriffen werden kann. Auf der strukturierten leitenden Schicht 15 ist eine weitere Isolationsschicht 17 aufgebracht. Auf dieser zweiten Isolationsschicht 17 können, falls es erforderlich ist, weitere leitende Schichten 15 aus mit Nanopartikeln gefülltem Kunststofflack im Wechsel mit Isolationsschichten 16, 17 aufgebracht werden und somit können die Randseiten 10, die Oberseiten 11 und die Rückseiten 12 des Halbleiterchips 1 oder 2 des Halbleiterchipstapels 100 mit einer mehrlagigen Umverdrahtungsstruktur 23 beschichtet sein.

Die elektrisch leitende Schicht 15 ist derart strukturiert, dass sich Leitungsabschnitte 7 bilden, die beispielsweise, wie es in Figur 1 gezeigt wird, eine Außenkontaktfläche 20 auf der Unterseite des Halbleiterchipstapels 100 über die Randseiten 10, sowie die Oberseiten 11 mit den Kontaktflächen 5 auf dem ersten und auf dem zweiten Halbleiterchip verbinden können. Diese Leitungsabschnitte entstehen dadurch, dass auf die erste Isolationsschicht 16 ein mit Nanopartikeln gefüllter Kunststofflack aufgebracht wird, der mittels Laserabtrag aufgeheizt wird, wobei die Lackkomponente sich verflüchtigt, während die Nanopartikel zu Leitungsabschnitten 7 verdichtet werden.

Derartige Leitungsabschnitte 7 können sich von der Unterseite des Halbleiterchipstapels 100 bis zur Oberseite 11 des Halbleiterchipstapels 100 erstrecken und dabei die Kontaktflächen 5 von beiden Halbleiterchips 1, 2 miteinander verbinden, ohne dass Durchätzungen durch die Halbleiterchips erforderlich werden. Die nicht zu Leitungsabschnitten 7 strukturierten Bereiche des mit Nanopartikeln gefüllten Kunststofflackes können in einem Lösungsbad aufgelöst und entfernt werden. Durch den Laserabtrag wird es möglich, sowohl auf der Unterseite des Halbleiterchipstapels 100, als auch auf den Oberseiten 11 der Halbleiterchips 1 und 2 des Halbleiterchipstapels 100, sowie auf den Randseiten 10 entsprechende Leitungsabschnitte 7 zu realisieren.

Die Kontaktfenster 19, auf der Unterseite des Halbleiterchipstapels 100, sind in dieser Ausführungsform mit einer Außenkontaktfläche 20 belegt, die einen Außenkontakt 21, der hier gestrichelt gezeigt ist, tragen können. Zur Verdeutlichung der Erfindung sind die Dimensionen nicht maßstabsgerecht, so kann beispielsweise die Beschichtung der Rückseiten 12, Randseiten 10 und Oberseiten 11 des Halbleiterchipstapels 100 von einem System aus einer Isolationsschicht 16, einer Leitungsschicht 15 und einer weiteren Isolationsschicht 17 eine Dicke d aufweisen, die nur wenige Mikrometer beträgt.

Die Halbleiterchips weisen eine Dicke D auf, die zwischen 50 µm und 700 µm liegen kann. Die stoffschlüssige Verbindungsschicht 22 kann einen Klebstoff oder ein Lötmaterial aufweisen in einer Dicke w, die ebenfalls nur wenige Mikrometer beträgt. Gegenüber diesen Dickenmaßen sind die Flächenmaße der Halbleiterchips wesentlich größer und können Dimensionen im Zentimeterbereich aufweisen. Die Kontaktflächen 5 auf den aktiven Oberseiten 11 der Halbleiterchips 1 und 2 sind hingegen ebenfalls nur mehrere 10 µm groß und können aufgrund der erfindungsgemäßen Leitungsabschnitte 7 aus nanogefülltem Kunststofflack weiterhin auf wenige Mikrometer im Quadrat verkleinert werden, womit eine hohe Dichte bei geringem Rastermaß bzw. geringer Schrittweite zwischen den Kontaktflächen 5 erreichbar ist.

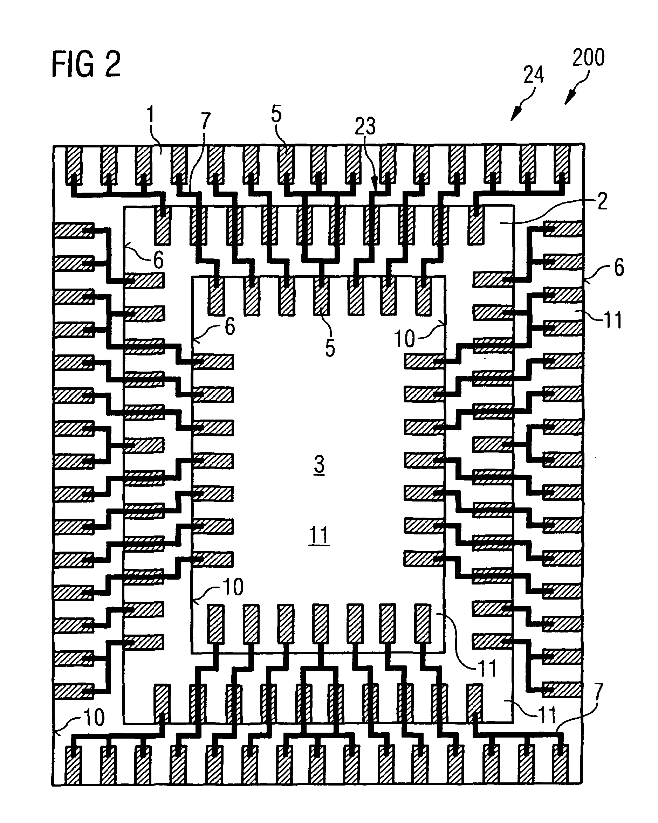

Figur 2 zeigt eine schematische Draufsicht auf ein Halbleiterbauteil 24 mit einem Halbleiterchipstapel 200 einer zweiten Ausführungsform der Erfindung. Diese Draufsicht zeigt drei aufeinander gestapelte Halbleiterchips 1, 2 und 3. Dabei nimmt die Größe der Oberseiten 11 der Halbleiterchips 1 bis 3 von 1 nach 3 ab, sodass das oberste Halbleiterchip 3 die kleinste Fläche aufweist und das unterste Halbleiterchip 1 die größte Fläche besitzt. Diese nach unten hin zunehmende Größe der Halbleiterchips 1 bis 3 wurde in dieser Ausführungsform gewählt, um mithilfe der Draufsicht die Umverdrahtungsstruktur 23 eines derartigen Halbleiterchipstapels 200 zu zeigen. Dabei verlaufen die Leitungsabschnitte 7 teilweise auf den Oberseiten 11 der Halbleiterchips und teilweise auf den Randseiten 10 der Halbleiterchips.

Die Kontaktflächen 5 reichen wiederum bei jedem der Halbleiterchips 1 bis 3 bis an die Kanten 6 heran, womit eine dreidimensionale Verdrahtung möglich wird. Die Abnahme der Größe der Oberseiten 11 der Halbleiterchips 1 bis 3 von dem untersten Halbleiterchip 1 bis zum obersten Halbleiterchip 3 ist bei der erfindungsgemäßen Umverdrahtungsstruktur 23 nicht zwingend erforderlich, da mithilfe beispielsweise des Laserabtragsverfahrens auch die Rückseiten, - wie es bereits die Figur 1 mit der Rückseite 12 des Halbleiterchips 1 zeigt -, der Halbleiterchips mit Leitungsabschnitten 7 versehen sein können. Das bedeutet, dass die Halbleiterchips 1 bis 3 im Prinzip eine beliebige Größe bei der Reihenfolge der Stapelung bei dieser neuen Verdrahtungstechnik aufweisen können, wie es in den nachfolgenden Figuren gezeigt wird.

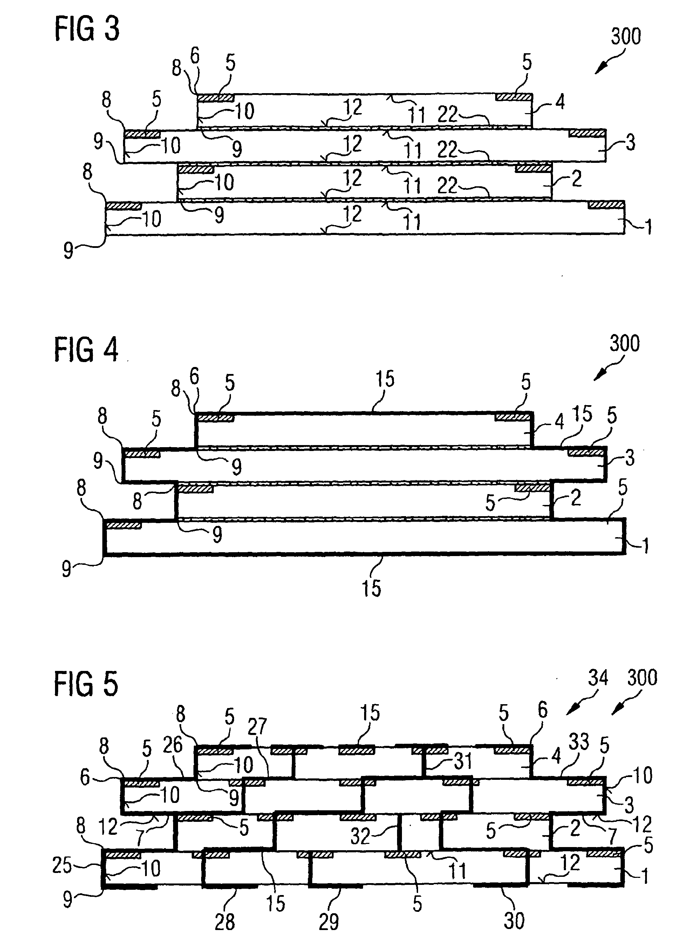

Die Figuren 3 bis 5 zeigen Stufen der Herstellung eines Halbleiterbauteils mit einem Halbleiterchipstapel einer dritten Ausführungsform der Erfindung.

Figur 3 zeigt dazu einen schematischen Querschnitt durch vier aufeinander gestapelte Halbleiterchips 1 bis 4 zur Herstellung eines Halbleiterbauteils 34 mit einem Halbleiterstapel 300 dieser dritten Ausführungsform der Erfindung. Von den vier aufeinander gestapelten Halbleiterchips 1 bis 4 weist der unterste Halbleiterchip 1 die größte aktive Oberseite 11 auf. Der auf dem Halbleiterchip 1 mit seiner Rückseite 12 gestapelte Halbleiterchip 2 weist eine demgegenüber kleinere aktive Oberseite 11 auf, sodass der dritte Halbleiterchip 3 über die Randseiten 10 des zweiten Halbleiterchips 2 hinausragt. Auf dem dritten Halbleiterchip 3 ist wiederum ein Halbleiterchip 4 mit einer kleineren aktiven Oberseite 11 angeordnet.

Die Halbleiterchips 1, 2, 3 und 4 sind stoffschlüssig mittels eines Klebstoffs über die Verbindungsschichten 22 verbunden.

Während die Kontaktflächen 5 der aktiven Oberseiten 11 der Halbleiterchips 1, 3 und 4 frei zugänglich sind, ist von den Kontaktflächen 5 des Halbleiterchips 2 die Oberseite 11 bedeckt, jedoch aufgrund der erfindungsgemäßen Heranführung der Kontaktflächen 5 an die Randseiten 10 des Halbleiterchips 2 sind die Randseiten 10 der Kontaktflächen 5 auch vom Halbleiterchip 2 kontaktierbar.

Ein derartig vorbereiteter Halbleiterchipstapel 300 kann nun mit einer elektrisch leitenden Schicht belegt werden.

Figur 4 zeigt einen schematischen Querschnitt eines Halbleiterchipstapels 300, der in Figur 3 gezeigt wird, nach Umhüllen des Halbleiterchipstapels 300 mit einer Nanopartikel aufweisenden Schicht 15. Diese Nanopartikel aufweisende Schicht 15 wird auf sämtliche Außenseiten des Halbleiterchipsstapels 300 aufgesprüht, indem ein Kunststofflack, der mit elektrisch leitenden Nanopartikeln gefüllt ist, aufgespritzt wird, oder indem der Halbleiterchipstapel in ein Bad mit einem Kunststofflack, der gefüllte Nanopartikel aufweist, eintaucht. Nach dem Trocknen des Lackes unter Vorhärten des Lackes kann dann diese Nanopartikel aufweisende Schicht 15 strukturiert werden.

Figur 5 zeigt eine Seitenansicht des Halbleiterbauteils 34 nach Strukturieren der Nanopartikel aufweisenden Schicht 15 gemäß Figur 4. Das Strukturieren des Halbleiterchipstapels 300 zu einem Halbleiterbauteil 34 wurde in der dritten Ausführungsform der Erfindung dadurch erreicht, dass ein Laserstrahl entlang der Spuren geführt wurde, die in Figur 5 schwarz gekennzeichnet sind. Dabei werden die Nanopartikel miteinander kontaktiert bis hin zum Verschweißen, während der Kunststofflack gleichzeitig verdampft. Dabei entstehen, wie in der Seitenansicht der Figur 5 gezeigt, Leiterbahnen 25 bis 33, die in unterschiedlicher Leiterbahnführung die unterschiedlichen Kontaktflächen 5 der Halbleiterchips 1 bis 4 untereinander bzw. miteinander verbinden. Die Kontaktflächen 5 des zweiten Halbleiterchips 2 des Halbleiterchipstapels 300 werden bei der Strukturierung auf ihren Randseiten 10 kontaktiert, zumal der Halbleiterchip 2, wie in Figur 4 gezeigt ist, kleiner ist als der darüber angeordnete Halbleiterchip 3. Damit ist die erfindungsgemäße Umverdrahtungstechnik in der Lage auch elektrische Verbindungen zu Kontaktflächen 5 zu schaffen, von denen nur ihr Querschnitt für den elektrischen Anschluss an eine Leiterbahn 7 zur Verfügung steht. Die Leiterbahnen 7 auf der Rückseite 12 des Halbleiterchips 3 werden bei dieser Stapelung der Halbleiterchips 1 bis 4 mit einer Umlenkoptik für einen Laser realisiert.

Es lassen sich mit dieser Technik die unterschiedlichsten Strukturen verwirklichen, wie es mit den hier gezeigten unterschiedlichen Leiterbahnen 25 bis 33 gezeigt wird. So können sich die Leiterbahnen verzweigen, wie es mit den Leiterbahnen 25, 26 und 27 gezeigt wird, oder sie werden zusammengeführt, wie es die Leiterbahnen 28, 30 und 31 zeigen. Oder sie dienen lediglich dazu, zwischen mehreren Halbleiterchips 1 bis 4 eine Verbindung herzustellen, wie es beispielsweise die Leiterbahnen 29, 32 und 33 dieser Seitenansicht zeigen. Ein derartiges einfaches Verdrahtungsmuster, das mit relativ preiswerten Fertigungsverfahren herstellbar ist, ist nur dadurch möglich, dass einerseits ein Nanopartikel aufweisender Kunststofflack eingesetzt wird und andererseits die Kontaktflächen der einzelnen Halbleiterchips 1 bis 4 bis an die Kanten des jeweiligen Halbleiterchips 1 bis 4 heran geführt werden.

## Patentansprüche

1. Halbleiterbauteil mit einem Stapel (100) aus Halbleiterchips (1, 2) unterschiedlicher Chipgrößen, wobei.die Halbleiterchips (1, 2) des Halbleiterchipstapels (100) mit frei wählbarer Reihenfolge der Stapelung stoffschlüssig aufeinander fixiert angeordnet sind, und wobei die Halbleiterchips (1, 2) Kontaktflächen (5) aufweisen, die sich bis an die Kanten (6) der Halbleiterchips (1, 2) erstrecken und wobei sich Leistungsabschnitte (7) von mindestens einer Oberkante (8) zu einer Unterkante (9) der Randseiten (10) der Halbleiterchips (1, 2) erstrecken und die Kontaktflächen (5) der Halbleiterchips (1, 2) des Halbleiterchipstapels (100) elektrisch verbinden, wobei die elektrisch leitenden Leitungsabschnitte (7) auf den Halbleiterchipkanten (6), den Halbleiterrandseiten (10), der Halbleiteroberseite (11) und/oder der Halbleiterrückseite (12) haftend angeordnet sind.

2. Halbleiterbauteil nach Anspruch 1,
**dadurch gekennzeichnet, dass**
die Halbleiterchips (1, 2) eine unterschiedliche Anzahl von Kontaktflächen (5) an ihren Kanten (6) aufweisen.

3. Halbleiterbauteil nach einem der vorhergehenden Ansprüche,
**dadurch gekennzeichnet, dass**
die Leitungsabschnitte (7) einen anhaftenden Kunststofflack aufweisen, der mit metallischen Nanopartikeln gefüllt ist und elektrisch leitet.

4. Halbleiterbauteil nach Anspruch 3,
**dadurch gekennzeichnet, dass**
der mit Nanopartikeln gefüllte Kunststofflack in einem Lösungsmittel löslich ist.

5. Halbleiterbauteil nach Anspruch 3 oder 4 ,
**dadurch gekennzeichnet, dass**
der mit Nanopartikeln gefüllte Kunststofflack mittels Laserabtrag strukturierbar ist.

6. Halbleiterbauteil nach Anspruch 3 oder 4 ,
**dadurch gekennzeichnet, dass**
der mit Nanopartikeln gefüllte Kunststofflack photolithographisch strukturierbar ist.

7. Halbleiterbauteil nach einem der vorhergehenden Ansprüche,
**dadurch gekennzeichnet, dass**
der Halbleiterchipstapel (100) eine mehrlagige Umverdrahtungsschicht, aus mit Nanopartikeln gefüllten elektrisch leitenden strukturierten Kunststofflackschichten (15) und dazwischen angeordneten Isolationsschichten (16, 17) auf den Randseiten (10) der Halbleiterchips (1, 2) aufweist.

8. Verfahren zur Herstellung eines Halbleiterbauteils mit einem Stapel (100) aus Halbleiterchips (1, 2) unterschiedlicher Chipgrößen, wobei das Verfahren folgende Verfahrensschritte aufweist:
- Herstellen von Halbleiterchips (1, 2) mit Kontaktflächen (5), die sich bis an die Kanten (6) des Halbleiterchips (1, 2) erstrecken,
- stoffschlüssiges Fixieren der Halbleiterchips (1, 2) übereinander zu einem Halbleiterstapel (100) mit frei wählbarer Reihenfolge der Stapelung,
- Umhüllen des Halbleiterstapels (100) mit einer Schicht (15) aus mit einem mit Nanopartikeln gefüllten Kunststofflack,
- Strukturieren der Schicht (15) zu Leiterbahnabschnitten (7) zwischen den Kontaktflächen (15) der aufeinander gestapelten Halbleiterchips (1, 2).

9. Verfahren nach Anspruch 8,
**dadurch gekennzeichnet, dass**
die Schicht (15) aus Kunststofflack zum Umhüllen des Halbleiterstapels (100) aufgesprüht wird.

10. Verfahren nach Anspruch 8 oder Anspruch 9,
**dadurch gekennzeichnet, dass**
der Halbleiterstapel (100) zum Umhüllen mit einer Schicht (15) aus Kunststofflack in ein Bad aus mit Nanopartikeln gefülltem Kunststofflack eingetaucht wird.

11. Verfahren nach einem der Ansprüche 8 bis 10,
**dadurch gekennzeichnet, dass**
zum Strukturieren des mit Nanopartikeln gefüllten Kunststofflack zu Leiterbahnabschnitten (7) ein Laserabtragsverfahren erfolgt.

12. Verfahren nach einem der Ansprüche 8 bis 10,
**dadurch gekennzeichnet, dass**
zum Strukturieren der mit Nanopartikeln gefüllten Schicht (15) aus Kunststofflack zu Leiterbahnabschnitten (7) ein Photolithographieverfahren durchgeführt wird.

13. Verfahren nach einem der Ansprüche 8 bis 10,
**dadurch gekennzeichnet, dass**
die Leiterbahnabschnitte (7) auf den Halbleiterstapel (100) selektiv mittels Präzisionsspritztechniken aufgebracht werden.

14. Verfahren nach einem der Ansprüche 8 bis 13,
**dadurch gekennzeichnet, dass**
mehrlagige Leiterbahnabschnitte (7) im Wechsel mit Isolationsschichten (16, 17) auf den Halbleiterstapel (100) aufgebracht werden.

## Claims

1. Semiconductor component comprising a stack (100) of semiconductor chips (1, 2) of different chip sizes, the semiconductor chips (1, 2) of the semiconductor chip stack (100) being arranged in a manner fixed cohesively one on top of another with a freely selectable stacking order, and the semiconductor chips (1, 2) having contact areas (5) extending as far as the edges (6) of the semiconductor chips (1, 2), and line sections (7) extending from at least one upper edge (8) to a lower edge (9) of the edge sides (10) of the semiconductor chips (1, 2) and electrically connecting the contact areas (5) of the semiconductor chips (1, 2) of the semiconductor chip stack (100), the electrically conductive line sections (7) being arranged adhesively on the semiconductor chip edges (6), the semiconductor edge sides (10), the semiconductor top side (11) and/or the semiconductor rear side (12).

2. Semiconductor component according to claim 1,
**characterized in that**
the semiconductor chips (1, 2) have a different number of contact areas (5) at their edges (6).

3. Semiconductor component according to one of the preceding claims,
**characterized in that**
the line sections (7) have an adherent plastic resist which is filled with metallic nanoparticles and is electrically conductive.

4. Semiconductor component according to Claim 3,
**characterized in that**
the nanoparticle-filled plastic resist is soluble in a solvent.

5. Semiconductor component according to claim 3 or 4,
**characterized in that**
the nanoparticle-filled plastic resist can be patterned by means of laser removal.

6. Semiconductor component according to Claim 3 or 4,
**characterized in that**
the nanoparticle-filled plastic resist can be patterned photolithographically.

7. Semiconductor component according to one of the preceding claims,
**characterized in that**
the semiconductor chip stack (100) has a multilayer rewiring layer comprising nanoparticle-filled electrically conductive patterned plastic resist layers (15) and insulation layers (16, 17) arranged in between on the edge sides (10) of the semiconductor chips (1, 2).

8. Method for producing a semiconductor component comprising a stack (100) of semiconductor chips (1, 2) of different chip sizes the method having the following method steps of:
- producing semiconductor chips (1, 2) with contact areas (5) extending as far as the edges (6) of the semiconductor chip (1, 2),
- cohesively fixing the semiconductor chips (1, 2) one above another to form a semiconductor stack (100) with a freely selectable stacking order,
- encapsulating the semiconductor stack (100) with a layer (15) made of a plastic resist which is filled with nanoparticles,
- patterning the layer (15) to form interconnect sections (7) between the contact areas (15) of the semiconductor chips (1, 2) stacked one on top of another.

9. Method according to Claim 8,
**characterized in that**
the layer (15) made of plastic resist for encapsulating the semiconductor stack (100) is sprayed on.

10. Method according to Claim 8 or Claim 9,
**characterized in that**
the semiconductor stack (100), for encapsulation with a layer (15) made of plastic resist, is dipped into a bath of nanoparticle-filled plastic resist.

11. Method according to one of Claims 8 to 10,
**characterized in that**
a laser removal method is effected for patterning the nanoparticle-filled plastic resist to form interconnect sections (7).

12. Method according to one of Claims 8 to 10,
**characterized in that**
a photolithography method is carried out for patterning the nanoparticle-filled layer (15) made of plastic resist to form interconnect sections (7) .

13. Method according to one of Claims 8 to 10,
**characterized in that**
the interconnect sections (7) are applied to the semiconductor stack (100) selectively by means of precision injection techniques.

14. Method according to one of Claims 8 to 13,
**characterized in that**
multilayer interconnect sections (7) in alternation with insulation layers (16, 17) are applied to the semiconductor stack (100).

## Revendications

1. Composant semi-conducteur qui présente un empilement (100) de puces semi-conductrices (1, 2) de différentes tailles, les puces semi-conductrices (1, 2) de l'empilement (100) de puces semi-conductrices étant fixées les unes sur les autres en correspondance de matière dans une succession d'empilement librement sélectionnée, dans lequel les puces semi-conductrices (1, 2) présentent des surfaces de contact (5) qui s'étendent jusqu'aux chants (6) des puces semi-conductrices (1, 2) et des parties de puissance (7) s'étendent depuis au moins un chant supérieur (8) jusqu'à un chant inférieur (9) des bordures (10) des puces semi-conductrices (1, 2) et relient électriquement les surfaces de contact (5) des puces semi-conductrices (1, 2) de l'empilement (100) de puces semi-conductrices, les parties de puissance (7) électriquement conductrices étant disposées de manière adhérente sur les chants (6) des puces semi-conductrices, les bordures semi-conductrices (10), le côté supérieur semi-conducteur (11) et/ou le côté arrière semi-conducteur (12).

2. Composant semi-conducteur selon la revendication 1, **caractérisé en ce que** les puces semi-conductrices (1, 2) présentent sur leurs chants (6) des nombres différents de surfaces de contact (5).

3. Composant semi-conducteur selon l'une des revendications précédentes, **caractérisé en ce que** les parties de puissance (7) présentent un vernis synthétique adhésif qui est chargé de nanoparticules métalliques et conduit l'électricité.

4. Composant semi-conducteur selon la revendication 3, **caractérisé en ce que** le vernis synthétique chargé de nanoparticules est soluble dans un solvant.

5. Composant semi-conducteur selon les revendications 3 ou 4, **caractérisé en ce que** le vernis synthétique chargé de nanoparticules peut être structuré par enlèvement au laser.

6. Composant semi-conducteur selon les revendications 3 ou 4, **caractérisé en ce que** le vernis synthétique chargé de nanoparticules peut être structuré par photolithographie.

7. Composant semi-conducteur selon l'une des revendications précédentes, **caractérisé en ce que** l'empilement (100) de puces semi-conductrices présente une multicouche électriquement conductrice et structurée de câblage des couches (15) de vernis synthétique chargé de nanoparticules et des couches d'isolation intercalaires (16, 17) sur les bordures (10) des puces semi-conductrices (1, 2).

8. Procédé de fabrication d'un composant semi-conducteur qui présente un empilement (100) de puces semi-conductrices (1, 2) de différentes tailles, lequel procédé présente les étapes suivantes :
fabrication de puces semi-conductrices (1, 2) dotées de surfaces de contact (5) qui s'étendent jusqu'aux chants (6) des puces semi-conductrices (1, 2),
fixation en correspondance de matière des puces semi-conductrices (1, 2) les unes au-dessus des autres pour former un empilement (100) semi-conducteur dans une succession d'empilement librement sélectionnée,
enrobage de l'empilement semi-conducteur (100) par une couche (15) de vernis synthétique chargé de nanoparticules,
structuration de la couche (15) en parties (7) de pistes conductrices entre les surfaces de contact (15) des puces semi-conductrices (1, 2) empilées les unes sur les autres.

9. Procédé selon la revendication 8, **caractérisé en ce que** la couche (15) en vernis synthétique est pulvérisée pour enrober l'empilement semi-conducteur (100).

10. Procédé selon la revendication 8 ou la revendication 9, **caractérisé en ce que** pour enrober l'empilement semi-conducteur (100) par une couche (15) de vernis synthétique, on l'immerge dans un bain de vernis synthétique chargé de nanoparticules.

11. Procédé selon l'une des revendications 8 à 10, **caractérisé en ce que** pour structurer le vernis synthétique chargé de nanoparticules en parties (7) de pistes conductrices, on utilise un procédé d'enlèvement au laser.

12. Procédé selon l'une des revendications 8 à 10, **caractérisé en ce que** pour structurer la couche (15) de vernis synthétique chargé de nanoparticules en parties (7) de pistes conductrices, on utilise un procédé de photolithographie.

13. Procédé selon l'une des revendications 8 à 10, **caractérisé en ce que** les parties (7) de pistes conductrices sont appliquées sélectivement sur l'empilement semi-conducteur (100) par des techniques de pulvérisation de précision.

14. Procédé selon l'une des revendications 8 à 13, **caractérisé en ce que** les parties (7) de pistes conductrices en plusieurs couches sont appliquées sur l'empilement semi-conducteur (100) en alternance avec des couches isolantes (16, 17).
